(19) Europäisches Patentamt
European Patent Office
Office européen des brevets

(11) **EP 2 590 330 B1**

(12) **EUROPEAN PATENT SPECIFICATION**

(45) Date of publication and mention
of the grant of the patent:
**27.08.2014  Bulletin 2014/35**

(51) Int Cl.:
***H03M 1/12*** *(2006.01)*    *H03M 1/36* *(2006.01)*

(21) Application number: **11187920.1**

(22) Date of filing: **04.11.2011**

(54) **Analog-to-digital converter**

Analog/Digital-Umsetzer

Convertisseur analogique-numérique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**08.05.2013  Bulletin 2013/19**

(73) Proprietor: **IHP GmbH-Innovations for High
Performance
Microelectronics / Leibniz-Institut für innovative
Mikroelektronik
15236 Frankfurt / Oder (DE)**

(72) Inventors:
• **Scheytt, Johann Christoph
15234 Frankfurt (Oder) (DE)**

• **Borokhowych, Yevgen
15230 Frankfurt (Oder) (DE)**

(74) Representative: **Eisenführ Speiser
Patentanwälte Rechtsanwälte PartGmbB
Anna-Louisa-Karsch-Strasse 2
10178 Berlin (DE)**

(56) References cited:
• **JANG Y-C ET AL: "AN 8.8-GS/S 6-BIT CMOS TIME-
INTERLEAVED FLASH ANALOG-TO-DIGITAL
CONVERTER WITH MULTI-PHASE CLOCK
GENERATOR", IEICE TRANSACTIONS ON
ELECTRONICS, INSTITUTE OF ELECTRONICS,
TOKYO, JP, vol. E90C, no. 6, 1 June 2007
(2007-06-01) , pages 1156-1164, XP001542079,
ISSN: 0916-8524, DOI: 10.1093/IETELE/E90-C.
6.1156**

EP 2 590 330 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field of the invention

The invention is in the field of analog-to-digital conversion and concerns an analog-to-digital converter as well as a method for analog-to-digital conversion.

Description of the Prior Art

A known technique according to the state of the art is simultaneous comparing of analog input signal with reference levels, and producing a digital output which represents the instantaneous analog input plus a quantization error.

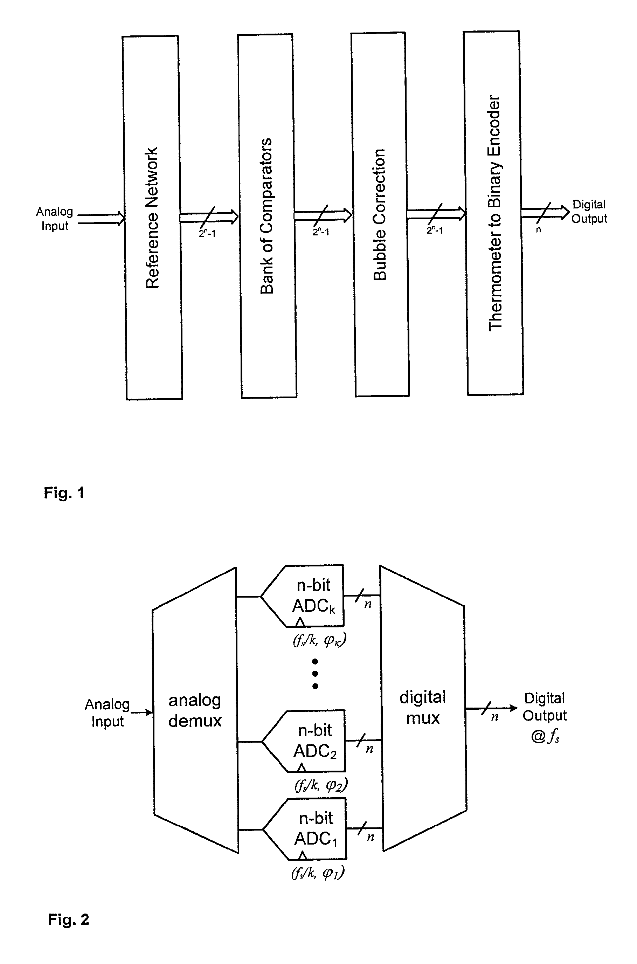

This technique is called a full flash ADC. The high-speed full flash ADC illustrated in Fig. 1, produces reference levels according to an analog input signal and digitizes those reference levels simultaneously with a bank of comparators, which are sampled by the common clock signal. To satisfy the Nyquist criteria the frequency of sample clock has to be at least two times higher than the maximum frequency of the input signal.

This requirement has a very big impact on the comparators, which with increasing the clock frequency have to operate at shorter sample (track) time and hold (latch) time. Shorter track and hold times of the comparators lead to following problems:

- During too short track time the comparator may not change its output from the saturated value to the midpoint value and properly amplify the input signal. It means that the comparator would not follow a new analog value.

- During too short latch time the comparator may not achieve its new saturated value. It means that the comparator would be in the metastable state.

- Comparators with short recovery and regeneration constants, that determine the performance during track and latch phases, dissipate extreme power.

A second technique according to the State of the art uses several analog-to-digital Converters in a time-interleaved configuration to increase the effective sample rate of the ADC. A general block-diagram of a time-interleaved ADC is shown in Fig. 2. By shifting the sample phase of the individual ADC it is possible to achieve an arbitrary high effective sample rate. The disadvantage of the time-interleaved ADC is that an analog demultiplexer is needed, which selects the individual ADC and feeds the analog input signal to its input.

The publication JANG Y-C et al.: "AN 8.8-GS/S 6-BIT CMOS TIME-INTERLEAVED FLASH ANALOG-TO-DIGITAL CONVERTER WITH MULTI-PHASE CLOCK GENERATOR", IEICE TRANSACTIONS ON ELECTRONICS, INSTITUTE OF ELECTRONICS, TOKYO, JP, vol. E90C, no. 6,1 June 2007 (2007-06-01), pages 1156-1164 discloses an ADC having the features of the pre-characterizing portion of claim 1.Summary of the Invention

According to a first aspect of the invention, an analogue-to-digital converter is provided. The analogue-to-digital converter (ADC) comprises

- an input unit configured to receive an analogue input signal;

- a reference unit, which is connected with the input unit and configured to provide a set of $2^n$-1 analogue reference signals, the set of reference signals as a whole forming a representation of a current amplitude of the input signal; and

- a parallel multi-phase sample unit (PMSU), which is connected with the reference unit and which is configured to receive or generate a clock signal and to periodically generate and provide at its output a set of $2^n$-1 m-bit wide digital output signals based on the set of the reference signals, each digital output signal being indicative of the values of a respective reference signal at the time of the clock signal and at the times of $m$ incremental time delays within a clock period of the clock signal.

In the ADC of the present invention, the PMSU comprises a set of $2^n$-1 clocked multi-phase sampling units (MSUs), wherein each of the multi-phase sampling units is configured to receive the clock signal, respective incrementally delayed clock signals, and a respective one of the reference signals. At least one of the multi-phase sampling units preferably comprises a set of $m$ latches connected to receive in parallel a respective one of the reference signals. A first of the latches is clocked by the clock signal, and the other of the latches are clocked by a respective one of the incrementally delayed clock signal.

The ADC may be implemented in accordance with one of the following embodiments. Additional features of different embodiments may be combined with each other to form additional embodiments.

In the ADC of one of the preceding embodiments, the PMSU unit advantageously comprises a delay-locked loop, which is configured to receive the clock signal and to generate and provide in parallel at its output within the clock period the set of $m$ incrementally delayed clock signals.

In another embodiment, the input unit is configured to receive a differential input signal to provide at its output a set of differential reference signals, and the reference unit comprises a differential resistive network and a set of preamplifiers, each preamplifier being connected and configured to amplify a respective differential reference signal in signal amplitude at a specific node of the resistive network.

An ADC of another embodiment further comprises a 2-dimentional thermometer-to-binary encoder, which on its input side is configured to receive $2^n$-1 m-bit wide output signals from the set of multi-phase sampling units, and to provide on its output side m n-bit binary words representing the output of the ADC.

Preferably, the ADC of one of the preceding embodiments further comprises an error correction unit, which is configured to detect that the set of output signal of the PMSU comprises a first bit indicating a presence of a first reference signal representing a first reference signal amplitude and at the same time comprises a second bit indicating an absence of a second reference signal representing a second reference signal amplitude lower than the first reference signal amplitude at a same point in time, and which is configured to modify, in case of detection of that situation, the second bit to assume the same value as the first bit.

In another implementation, an ADC configured for a time-interleaved operation has a set of k sub-ADCs arranged in a parallel configuration, which is configured to be directly fed in parallel with an analogue input signal, each of the sub-ADCs being in accordance with one of the preceding embodiments of the ADC of the first aspect of the invention, and being configured to be operated with a respective clock signal exhibiting an incremental shift in clock phase within the same clock period in regard to a respective neighbouring sub-ADC of the set. The outputs of the sub-ADCs of the set are connected to a digital multiplexer.

According to a second aspect of the invention, a method for converting an analogue input signal into a digital output signal is provided. Embodiments of the method are subsequently presented.

The method comprises:

- providing an analogue input signal;

- providing a set of $2^n$-1 analogue reference signals, the set of reference signals as a whole forming a representation of a current amplitude of the input signal; and

- periodically, driven by a clock signal, generating and providing a set of $2^n$-1 m-bit wide digital output signals based on the set of reference signals, each digital output signal being indicative of the values of a respective reference signal at the time of the clock signal and at the times of m incremental time delays within a clock period of the clock signal.

The method further comprises providing the reference signals to $2^n$-1 clocked multi-phase sampling units , wherein each of the multi-phase sampling units receives a respective set of m incrementally delayed clock signals and a respective one of the reference signals. At least one of the MSUs comprises a set of $m$ latches connected to receive in parallel a respective one of the reference signals, and a first of the latches is clocked by the clock signal, and the other of the latches are clocked by a respective one of the incrementally delayed clock signals.

As before, the additional features of the following method embodiments may be combined with that of the method of the second aspect of the invention, and with each other, to form further embodiments.

One embodiment further comprises

- receiving a differential input signal;

- providing the set of reference signals in differential form by means of a differential resistive network; and

- amplifying a respective differential reference signal in signal amplitude at a specific node of the resistive network.

In a further embodiment, the method comprises additionally

- receiving $2^n$-1 m-bit wide output signals from the set of multi-phase sampling units,

- encoding the output signals;

- providing a *m* n-bit wide binary encoded output words representing the output of the ADC.

Any of the method embodiments above may additionally comprise

- detecting that the set of output signals comprises a first bit indicating a presence of a first reference signal representing a first reference signal amplitude and at the same time comprises a second bit indicating an absence of a second reference signal representing a second reference signal amplitude lower than the first reference signal amplitude at a same point in time, and
- in case of detection of that situation, modifying the second bit to assume the same value as the first bit.

A method of operating an ADC in a time-interleaved configuration comprises

- directly providing an analogue input signal to a set of *k* sub-ADC processes operating in parallel, each of the sub-ADC processes being in accordance with the method of the second aspect of the invention or one of its preceding embodiments and being operated with a respective clock signal exhibiting an incremental shift in clock phase within the same clock period in regard to a respective neighbouring sub-ADC process of the set, and

- multiplexing the outputs of the sub-ADC processes.

In the following, advantages of the invention are described. The invention allows achieving

a) Lower system clock ($f_{stop}$): D-Latches in MSU work at lower system clock rate, enabling longer regeneration time and relaxed requirements for recovery time of the latch;

b) Easier clock distribution because of the lower clock frequency. The required power for the clock tree is lower;

c) Lower clock rate results in a reduced clock feed through;

d) High effective sample rate equal to system clock multiplied to $2^{resolution\ of\ MSU}$. ADC satisfies the Nyquist criteria;

e) Output Codes are parallel bit sequences that are similar to demultiplexing function;

f) Easier encoding due to lower digital clock frequency;

g) Possible compensation of clock and/or signal distribution imperfection;

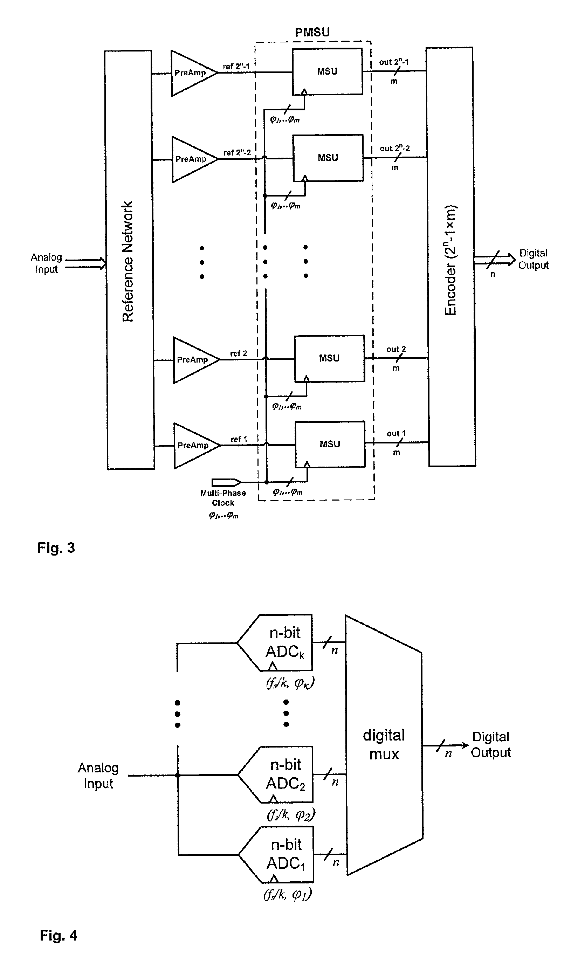

h) Simplified use of the ADC in time-interleaved configuration. Analog inputs of the sub-ADCs can be connected together (cf. also the embodiment of Fig. 4).

i) The embodiment of a time-interleaved ADC does not need an additional analog demultiplexer.

Further possible embodiments of the ADC are addressed in the following.

One embodiment of the proposed ADC is a full flash ADC that has a block which generates reference levels based on the analog input signal. This block as example can be implemented as a differential resistor ladder, but other implementations are also possible.

The set of reference signals may be amplified with a bank of preamplifiers and digitized with a bank of m-bit multi-phase sampling units (MSUs).

Each of the $2^n$-1 MSUs, where n is a resolution of ADC, detects and measures a time interval between zero-crossing events of a respective incrementally delayed clock signal and a respective clock signal (CLK) provided to the MSU on its input side. Results are coded in $2^n$-1 m-bit output words.

The discretization step is equal to the time resolution $T_{res}$ of the MSU and can be calculated by:

$$T_{res} = \frac{1}{f_{CLK} \cdot m} \tag{1}$$

The frequency $f_{CLK}$ of the clock signal can be lower than the Nyquist frequency. An effective sample rate of the ADC is defined by the time resolution $T_{res}$ and is equal to

$$f_{eff} = \frac{1}{T_{res}} \qquad\qquad (2)$$

The output of the bank of MSUs can be represented as a matrix with dimensions $2^n\text{-}1 \times m$, where n is a resolution of ADC, and *m* is the number of clock phases fed to the MSUs. Each column of the matrix represents a thermometer-coded output like in a conventional full flash ADC, i.e. a digitized input signal value while a different column represents a different sampling time.

The invention forms a solution which allows converting an analog signal into digital form with equivalent sample rate which is m times higher than system clock. The converter has to satisfy the Nyquist criteria.

The invention proposes as one embodiment a configuration of the converter which can be used in time-interleaved converters without the requirement of an analog demultiplexer, i.e., provides a converter that has inherent demultiplexer properties.

Finally, a simplified error correction can be achieved in embodiments employing parallel processing.

Bubble errors are a known problem of the full flash ADCs. They occur due to imperfection in clock and/or signal paths. The proposed ADC has possibility of locating the bubble errors and correct it digitally.

To locate the possible bubble errors due to clock skew, the inputs of all MSUs have to be simultaneously changed and the output matrix has to be analyzed for the bubbles. For illustration, assuming that the resolution of ADC is 3 bits and the resolution of the MSU is 7 bits. Changing inputs of all MSUs from "0" to "1", the output matrix of ADC will look like:

$$
\begin{array}{ccccccc}
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 1 & 1 & 1 & 1 & 1 \\
\end{array} \qquad\qquad (3)
$$

The main property of an error-free matrix is that all columns contain either "0" or "1".

If the output matrix contains errors, they can be located by finding value, which differs from majority values in the column. Erroneous values can be corrected digitally.

For example if the second from bottom MSU has a clock delay, the output of ADC may look like:

$$
\begin{array}{ccccccc}
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 1 & 1 & 1 & 1 & 1 \\
0 & 0 & 0 & 0 & 1 & 1 & 1 \\
0 & 0 & 1 & 1 & 1 & 1 & 1 \\
\end{array} \qquad\qquad (4)
$$

For this particular example, the second from bottom line has to be shifted two positions to the left. This shift can be performed during a digital processing at the low clock rates.

Brief Description of the Drawings

Fig. 1    shows a block diagram of a full flash ADC according to prior art;

Fig. 2    shows a time-interleaved ADC according to the prior art;

Fig. 3    shows an embodiment of an ADC according to an embodiment of the present invention;

Fig. 4    shows an embodiment of a proposed time-interleaved ADC with sub-ADCs according to the invention; and

Fig. 5    shows another possible implementation of the ADC according to an embodiment of the present invention.

Description of Further Embodiments with Reference to the Figures

A simplified block diagram showing an embodiment of an ADC according to the present invention is shown in Fig. 3.

Fig. 4 shows an example of time-interleaved ADC.

The proposed ADC can be connected in a time-interleaved configuration. The time-interleaved ADC based on sub-ADCs according to the present invention does not require an analog demultiplexer, its function is performed by the MSUs. The MSU samples the input signal in the defined time frame. This property is similar to a function of an analog demultiplexer.

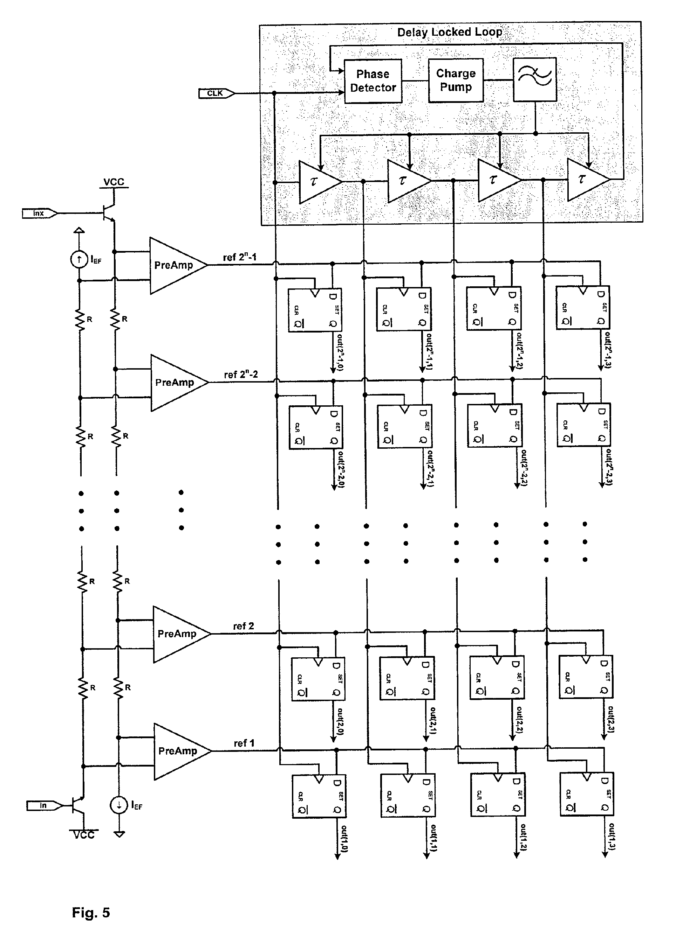

One of the possible implementations of the full flash analog-to-digital converter according to the invention is shown in Fig. 5, which illustrates the invention using a Delay-Locked Loop based parallel multi-phase sampling unit (PMSU). Reference voltage levels in this implementation are generated with a differential resistor ladder. Then the reference voltage levels are amplified and digitized by the PMSU. This PMSU comprises a delay locked loop (DLL), common for all MSUs and a set of multi-phase sampling units (MSU), each of them consisting of a bank of latches. The DLL generates a set of clock signals for the latches; each clock signal is shifted in time domain by the time interval $T$. The DLL controls that $T$ is equal to 1/4 of the clock signal period, for this example. Because four latches are used to digitize each reference level, the effective sample rate is four times higher than clock signal frequency.

Outputs of the latches out(1,0)... out ($2^n$-1,3) are the outputs of the ADC. In this example they are grouped in matrix with dimension ($2^n$-1,4). Outputs can be converted further in any desired digital format.

**Claims**

1.  An analogue-to-digital converter (ADC), comprising

    - an input unit configured to receive an analogue input signal;
    - a reference unit, which is connected with the input unit and configured to provide a set of $2^n$-1 analogue reference signals, the set of reference signals as a whole forming a representation of a current amplitude of the input signal; and
    - a parallel multi-phase sampling unit, hereinafter PMSU, which is connected with the reference unit and which is configured to receive or generate a clock signal and to periodically generate and provide at its output a set of $2^n$-1 m-bit wide digital output signals based on the set of reference signals, each digital output signal being indicative of the values of a respective reference signal at the time of the clock signal and at the times of m incremental time delays within a clock period of the clock signal,
    - wherein the PMSU comprises a set of $2^n$-1 clocked multi-phase sampling units, hereinafter MSUs, wherein each of the MSUs is configured to receive the clock signal, respective incrementally delayed clock signals, and a respective one of the reference signals, **characterized in that**
    - at least one of the MSUs comprises a set of $m$ latches connected to receive in parallel a respective one of the reference signals, wherein a first of the latches is clocked by the clock signal, and the other of the latches are clocked by a respective one of the incrementally delayed clock signals.

2.  The ADC of claim 1, wherein the PMSU unit comprises a delay-locked loop, which is configured to receive the clock signal and to generate and provide in parallel at its output within the clock period the set of $m$ incrementally delayed clock signals.

3. The ADC of one of the preceding claims, wherein the input unit is configured to receive a differential input signal to provide at its output a set of differential reference signals, and wherein the reference unit comprises a differential resistive network and a set of preamplifiers, each preamplifier being connected and configured to amplify a respective differential reference signal in signal amplitude at a specific node of the resistive network.

4. The ADC of one of the preceding claims, further comprising a 2-dimensional thermometer-to-binary encoder, which is configured to receive on its input side $2^n-1$ m-bit wide output signals from the set of multi-phase sampling units , and to provide on its output side $m$ n-bit binary words representing the output of the ADC.

5. The ADC of one of the preceding claims, comprising an error correction unit, which is configured to detect that the set of output signals of the PMSU comprises a first bit indicating a presence of a first reference signal representing a first reference signal amplitude and at the same time comprises a second bit indicating an absence of a second reference signal representing a second reference signal amplitude lower than the first reference signal amplitude at a same point in time, and which is configured to modify, in case of detection of that situation, the second bit to assume the same value as the first bit.

6. An ADC configured for a time-interleaved operation, wherein a set of k sub-ADCs arranged in a parallel configuration is configured to be directly fed in parallel with an analogue input signal, each of the sub-ADCs being in accordance with one of the preceding claims and being configured to be operated with a respective clock signal exhibiting an incremental shift in clock phase within the same clock period in regard to a respective neighbouring sub-ADC of the set, and wherein the outputs of the sub-ADCs of the set are connected to a digital multiplexer.

7. A method for converting an analogue input signal into a digital output signal, the method comprising

 - providing an analogue input signal;
 - providing a set of $2^n-1$ analogue reference signals, the set of reference signals as a whole forming a representation of a current amplitude of the input signal; and
 - periodically, driven by a clock signal, generating and providing a set of $2^n-1$ m-bit wide digital output signals based on the set of reference signals, each digital output signal being indicative of the values of a respective reference signal at the time of the clock signal and at the times of *m-1* incremental time delays within a clock period of the clock signal,
 - providing the reference signals to $2^n-1$ clocked MSUs, wherein each of the MSUs receives a respective set of m incrementally delayed clock signals and a respective one of the reference signals, **characterized in that**
 - at least one of the MSUs comprises a set of *m* latches connected to receive in parallel a respective one of the reference signals, and a first of the latches is clocked by the clock signal, and the other of the latches are clocked by a respective one of the incrementally delayed clock signals.

8. The method of claim 7, further comprising

 - receiving a differential input signal;
 - providing the set of reference signals in differential form by means of a differential reference network; and
 - amplifying a respective differential reference signal in signal amplitude at a specific node of the reference network.

9. The method of one of the claims 7 or 8, further comprising

 - receiving $2^n-1$ m-bit wide output signals from the set of MSUs,
 - encoding the output signals;
 - providing $m$ n-bit binary encoded output words representing the output of the ADC.

10. The method of one of the claims 7 to 9, further comprising

 - detecting that the set of output signals comprises a first bit indicating a presence of a first reference signal representing a first reference signal amplitude and at the same time comprises a second bit indicating an absence of a second reference signal representing a second reference signal amplitude lower than the first reference signal amplitude at a same point in time, and
 - in case of detection of that situation, modifying the second bit to assume the same value as the first bit.

11. A method of operating an ADC in a time-interleaved configuration, comprising

- directly providing an analogue input signal to a set of k sub-ADC processes operating in parallel, each of the sub-ADC processes being in accordance with one of the preceding claims 7 to 10 and being operated with a respective clock signal exhibiting an incremental shift in clock phase within the same clock period in regard to a respective neighbouring sub-ADC process of the set,
- multiplexing the outputs of the sub-ADC processes.

**Patentansprüche**

1. Analog-Digital-Wandler (ADW), umfassend

- eine Eingangseinheit, die ausgebildet ist, ein analoges Eingangssignal zu empfangen;
- eine Referenzeinheit, die mit der Eingangseinheit verbunden ist und ausgebildet ist, einen Satz von $2^n-1$ analogen Referenzsignalen bereitzustellen, wobei der Satz Referenzsignale als Ganzes eine Repräsentation einer aktuellen Amplitude des Eingangssignals bildet; und
- eine parallele Multiphasen-Abtasteinheit, im Folgenden PMSU, die mit der Referenzeinheit verbunden ist und die ausgebildet ist, ein Taktsignal zu empfangen oder zu erzeugen und periodisch einen Satz von $2^{n-1}$ m-Bit breiten digitalen Ausgabesignalen basierend auf dem Satz von Referenzsignalen zu erzeugen und an ihrem Ausgang bereitzustellen, wobei jedes digitale Ausgangssignal die Werte eines jeweiligen Referenzsignals zum Zeitpunkt des Taktsignals und zu den Zeitpunkten von m inkrementellen Zeitverzögerungen innerhalb einer Taktperiode des Taktsignals anzeigt,
- wobei die PMSU einen Satz von $2^n-1$ getakteten Multiphasen-Abtasteinheiten, im Folgenden MSU, umfasst, wobei jede MSU ausgebildet ist, das Taktsignal, entsprechende inkrementell verzögerte Taktsignale und ein jeweiliges der Referenzsignale zu empfangen, **dadurch gekennzeichnet dass**
- wenigstens eine der MSUs einen Satz von m Latches umfasst, die verbunden sind, um parallel ein jeweiliges der Referenzsignale zu empfangen, wobei ein erstes der Latches durch das Taktsignal getaktet ist und die anderen der Latches durch ein entsprechendes der inkrementell verzögerten Taktsignale getaktet sind.

2. ADW nach Anspruch 1, wobei die PMSU-Einheit eine Verzögerungsregelschleife umfasst, die ausgebildet ist, das Taktsignal zu empfangen und den Satz von m inkrementell verzögerten Taktsignalen zu erzeugen und parallel an ihrem Ausgang innerhalb der Taktperiode bereitzustellen.

3. ADW nach einem der vorstehenden Ansprüche, wobei die Eingangseinheit ausgebildet ist, ein differenzielles Eingangssignal zu empfangen, um an ihrem Ausgang einen Satz differenzieller Referenzsignale bereitzustellen, und wobei die Referenzeinheit ein differenzielles Widerstandsnetzwerk und einen Satz von Vorverstärkern umfasst, wobei jeder Vorverstärker verbunden und ausgebildet ist, ein jeweiliges differenzielles Referenzsignal in seiner Signalamplitude an einem spezifischen Knoten des Widerstandsnetzwerks zu verstärken.

4. ADW nach einem der vorstehenden Ansprüche, weiterhin umfassend einen zweidimensionalen Thermometer-zu-Binär-Kodierer, der ausgebildet ist, an seiner Eingangsseite $2^n-1$ m-Bit breite Ausgangssignale von dem Satz von Multiphasen-Abtasteinheiten zu empfangen und an seiner Ausgangsseite m binäre n-Bit Wörter bereitzustellen, die den Ausgang des ADW repräsentieren.

5. ADW nach einem der vorstehenden Ansprüche, umfassend eine Fehlerkorrektureinheit, die ausgebildet ist zu detektieren, dass der Satz von Ausgangssignalen der PMSU ein erstes Bit umfasst, das die Präsenz eines ersten Referenzsignals anzeigt, welches eine erste Referenzsignalamplitude repräsentiert, und zeitgleich ein zweites Bit umfasst, das die Abwesenheit eines zweiten Referenzsignals, welches eine zweite Referenzsignalamplitude repräsentiert, die kleiner ist als die erste Referenzsignalamplitude, zum gleichen Zeitpunkt anzeigt, und die ausgebildet ist, im Fall des Erkennens dieser Situation das zweite Bit zur Annahme desselben Werts wie der des ersten Bits zu modifizieren.

6. Analog-Digital-Wandler (ADW), der für einen zeitverschachtelten Betrieb ausgebildet ist, wobei ein Satz von k Sub-ADWs, die in einer parallelen Konfiguration angeordnet sind, ausgebildet ist, in paralleler Weise direkt mit einem analogen Eingangssignal versorgt zu werden, wobei jeder der Sub-ADWs im Einklang mit einem der vorstehenden Ansprüche ist und ausgebildet ist, mit einem jeweiligen Taktsignal, das eine inkrementelle Verschiebung in der Taktphase in der gleichen Taktperiode in Bezug auf einen jeweiligen benachbarten Sub-ADW des Satzes aufweist, betrieben zu werden, und wobei die Ausgänge der Sub-ADWs des Satzes mit einem digitalen Multiplexer verbunden sind.a

7. Verfahren zum Wandeln eines analogen Eingangssignals in ein digitales Ausgangssignal, umfassend

   - Bereitstellen eines analogen Eingangssignals
   - Bereitstellen eines Satzes von $2^n$-1 analogen Referenzsignalen, wobei der Satz Referenzsignale als Ganzes eine Repräsentation einer aktuellen Amplitude des Eingangssignals bildet; und
   - angetrieben durch ein Taktsignal, periodisches Erzeugen und Bereitstellen eines Satzes von $2^n$-1 m-Bit breiten digitalen Ausgabesignalen basierend auf dem Satz von Referenzsignalen, wobei jedes digitale Ausgangssignal die Werte eines jeweiligen Referenzsignals zum Zeitpunkt des Taktsignals und zu den Zeitpunkten von m-1 inkrementellen Zeitverzögerungen innerhalb einer Taktperiode des Taktsignals anzeigt,
   - Bereitstellen der Referenzsignale an $2^n$-1 getaktete MSUs, wobei jede der MSUs einen jeweiligen Satz von m inkrementell verzögerten Taktsignalen und ein jeweiliges der Referenzsignale zu empfangen, **dadurch gekennzeichnet dass**
   - wenigstens eine der MSUs einen Satz von m Latches umfasst, die verbunden sind, um parallel jeweiliges der Referenzsignale zu empfangen, und ein erstes der Latches durch das Taktsignal getaktet wird und die anderen der Latches durch ein entsprechendes der inkrementell verzögerten Taktsignale getaktet werden.

8. Verfahren nach Anspruch 7, weiter umfassend

   - Empfangen eines differenziellen Eingangssignals;
   - Bereitstellen des Satzes von Referenzsignalen in differenzieller Form mittels eines differenziellen Referenznetzwerks; und
   - Verstärken eines jeweiligen differenziellen Referenzsignals in seiner Signalamplitude an einem spezifischen Knoten des Referenznetzwerks.

9. Verfahren nach einem der Ansprüche 7 oder 8, weiter umfassend:

   - Empfangen von $2^n$-1 m-Bit breiten Ausgangssignalen von dem Satz von MSUs,
   - Kodieren der Ausgangssignale;
   - Bereitstellen von m n-Bit binären kodierten Ausgangswörtern, die die Ausgabe des ADC repräsentieren.

10. Verfahren nach einem der Ansprüche 7 bis 9, weiter umfassend

   - Detektieren, dass der Satz von Ausgangssignalen ein erstes Bit umfasst, das das Vorhandensein eines ersten Referenzsignals anzeigt, welches eine erste Referenzsignalamplitude repräsentiert, und gleichzeitig ein zweites Bit umfasst, das eine Abwesenheit eines zweiten Referenzsignals anzeigt, welches eine zweite Referenzsignalamplitude repräsentiert, die kleiner als die erste Referenzsignalamplitude zum selben Zeitpunkt ist" und
   - im Fall des Detektierens dieser Situation, Modifizieren des zweiten Bits, um denselben Wert wie das erste Bit anzunehmen.

11. Verfahren zum Betreiben eines ADW in einer zeitverschachtelten Konfiguration, umfassend

   - direktes Bereitstellen eines analogen Inputsignals zu einem Satz von k parallel arbeitenden Sub-ADW-Prozessen, wobei jeder Sub-ADW-Prozess im Einklang mit einem der vorstehenden Ansprüche 7 bis 10 ist und mit einem jeweiligen Taktsignal betrieben wird, welches eine inkrementelle Verschiebung in der Taktphase innerhalb derselben Taktperiode in Bezug auf einen jeweiligen benachbarten Sub-ADW-Prozess des Satzes aufweist,
   - Multiplexen der Ausgänge der Sub-ADW-Prozesse.

**Revendications**

1. Convertisseur analogique à numérique (ADC), comprenant :

   - une unité d'entrée configurée de manière à recevoir un signal d'entrée analogique ;
   - une unité de référence, qui est connectée à l'unité d'entrée et configurée de manière à fournir un ensemble

de $2^n$-1 signaux de référence analogiques, l'ensemble de signaux de référence formant dans sa totalité une représentation d'une amplitude en cours du signal d'entrée ; et

- une unité d'échantillonnage à phases multiples en parallèle, ci-après appelée PMSU, qui est connectée à l'unité de référence et qui est configurée de manière à recevoir ou à générer un signal d'horloge, et à générer et à fournir périodiquement, à sa sortie, un ensemble de $2^n$-1 signaux de sortie numériques de m bits, sur la base de l'ensemble de signaux de référence, chaque signal de sortie numérique étant indicatif des valeurs d'un signal de référence respectif à l'instant du signal d'horloge et aux instants de m retards temporels incrémentiels dans une période d'horloge du signal d'horloge ;

- dans lequel l'unité PMSU comporte un ensemble de $2^n$-1 unités d'échantillonnage à phases multiples cadencées, ci-après appelées MSU, dans lequel chacune des unités MSU est configurée de manière à recevoir le signal d'horloge, des signaux d'horloge retardés de manière incrémentielle respectifs, et l'un respectif des signaux de référence, **caractérisé en ce que** :

- au moins l'une des unités MSU comporte un ensemble de m verrous connectés de manière à recevoir en parallèle l'un respectif des signaux de référence, dans lequel un premier des verrous est cadencé par le signal d'horloge, et les autres des verrous sont cadencés par l'un respectif des signaux d'horloge retardés de manière incrémentielle.

2.  Convertisseur ADC selon la revendication 1, dans lequel l'unité PMSU comprend une boucle à verrouillage de retard, laquelle est configurée de manière à recevoir le signal d'horloge et à générer et à fournir en parallèle, au niveau de sa sortie, au sein de la période d'horloge, l'ensemble de m signaux d'horloge retardés de manière incrémentielle.

3.  Convertisseur ADC selon l'une quelconque des revendications précédentes, dans lequel l'unité d'entrée est configurée de manière à recevoir un signal d'entrée différentiel, en vue de fournir, au niveau de sa sortie, un ensemble de signaux de référence différentiels, et dans lequel l'unité de référence comprend un réseau résistif différentiel et un ensemble de préamplificateurs, chaque préamplificateur étant connecté et configuré de manière à amplifier un signal de référence différentiel respectif, en termes d'amplitude de signal, au niveau d'un noeud spécifique du réseau résistif.

4.  Convertisseur ADC selon l'une quelconque des revendications précédentes, comprenant en outre un codeur de code thermomètre en code binaire bidimensionnel, qui est configuré de manière à recevoir, sur son côté d'entrée, $2^n$-1 signaux de sortie de m bits en provenance de l'ensemble d'unités d'échantillonnage à phases multiples, et à fournir, sur son côté de sortie, *m* mots binaires de n bits représentant la sortie du convertisseur ADC.

5.  Convertisseur ADC selon l'une quelconque des revendications précédentes, comprenant une unité de correction d'erreurs, laquelle est configurée de manière à détecter que l'ensemble de signaux de sortie de l'unité PMSU comprend un premier bit indiquant la présence d'un premier signal de référence représentant une première amplitude de signal de référence, et qu'il comprend en même temps un second bit indiquant l'absence d'un second signal de référence représentant une seconde amplitude de signal de référence, inférieure à la première amplitude de signal de référence, à un même instant donné, et laquelle est configurée de manière à modifier, lorsque cette situation est détectée, le second bit, afin qu'il prenne la même valeur que le premier bit.

6.  Convertisseur ADC configuré pour une opération entrelacée dans le temps, dans lequel un ensemble de k sous-convertisseurs ADC agencés dans une configuration en parallèle est configuré de manière à être appliqué directement en parallèle avec un signal d'entrée analogique, chacun des sous-convertisseurs ADC étant selon l'une quelconque des revendications précédentes, et étant configuré de manière à être exploité avec un signal d'horloge respectif présentant un décalage incrémentiel en termes de phase d'horloge au sein de la même période d'horloge relativement à un sous-convertisseur ADC voisin respectif de l'ensemble, et dans lequel les sorties des sous-convertisseurs ADC de l'ensemble sont connectées à un multiplexeur numérique.

7.  Procédé de conversion d'un signal d'entrée analogique en un signal de sortie numérique, le procédé comprenant l'étape consistant à :

   - fournir un signal d'entrée analogique ;
   - fournir un ensemble de $2^n$-1 signaux de référence analogiques, l'ensemble de signaux de référence formant, dans sa totalité, une représentation d'une amplitude en cours du signal d'entrée ; et
   - périodiquement, sous la commande d'un signal d'horloge, générer et fournir un ensemble de $2^n$-1 signaux de sortie numériques de m bits, sur la base de l'ensemble de signaux de référence, chaque signal de sortie numérique étant indicatif des valeurs d'un signal de référence respectif à l'instant du signal d'horloge et aux instants de $m$-1 retards temporels incrémentiels au sein d'une période d'horloge du signal d'horloge ;
- fournir les signaux de référence à $2^n$-1 unités MSU cadencées, dans lequel chacune des unités MSU reçoit un ensemble respectif de m signaux d'horloge retardés de manière incrémentielle et l'un respectif des signaux de référence, **caractérisé en ce que** :
- au moins l'une des unités MSU comporte un ensemble de $m$ verrous connectés de manière à recevoir en parallèle l'un respectif des signaux de référence, et un premier des verrous est cadencé par le signal d'horloge, et les autres des verrous sont cadencés par l'un respectif des signaux d'horloge retardés de manière incrémentielle.

8. Procédé selon la revendication 7, comprenant l'étape consistant en outre à :

- recevoir un signal d'entrée différentiel ;
- fournir l'ensemble de signaux de référence sous une forme différentielle au moyen d'un réseau de référence différentiel ; et
- amplifier un signal de référence différentiel respectif, en termes d'amplitude de signal, au niveau d'un noeud spécifique du réseau de référence.

9. Procédé selon l'une quelconque des revendications 7 ou 8, comprenant l'étape consistant en outre à :

- recevoir $2^n$-1 signaux de sortie de m bits en provenance de l'ensemble d'unités MSU ;
- coder les signaux de sortie ;
- fournir $m$ mots de sortie codés binaires de n bits représentant la sortie du convertisseur ADC.

10. Procédé selon l'une quelconque des revendications 7 à 9, comprenant l'étape consistant en outre à :

- détecter que l'ensemble de signaux de sortie comprend un premier bit indiquant la présence d'un premier signal de référence représentant une première amplitude de signal de référence, et qu'il comprend en même temps un second bit indiquant l'absence d'un second signal de référence représentant une seconde amplitude de signal de référence, inférieure à la première amplitude de signal de référence, à un même instant donné ; et
- lorsque cette situation est détectée, modifier le second bit afin qu'il prenne la même valeur que le premier bit.

11. Procédé d'exploitation d'un convertisseur ADC dans une configuration entrelacée dans le temps, comprenant l'étape consistant à :

- fournir directement un signal d'entrée analogique à un ensemble de k processus de sous-convertisseur ADC exploités en parallèle, chacun des processus de sous-convertisseur ADC étant selon l'une quelconque des revendications 7 à 10, et étant exploité avec un signal d'horloge respectif présentant un décalage incrémentiel, en termes de phase d'horloge, au sein de la même période d'horloge, relativement à un processus de sous-convertisseur ADC voisin respectif de l'ensemble ;
- multiplexer les sorties des processus de sous-convertisseur ADC.

Analog Input → | Reference Network | —$2^n$-1→ | Bank of Comparators | —$2^n$-1→ | Bubble Correction | —$2^n$-1→ | Thermometer to Binary Encoder | —$n$→ Digital Output

**Fig. 1**

Analog Input → analog demux → n-bit $ADC_k$ $(f_s/k, \varphi_K)$ —$n$→

⋮

n-bit $ADC_2$ $(f_s/k, \varphi_2)$ —$n$→

n-bit $ADC_1$ $(f_s/k, \varphi_1)$ —$n$→

→ digital mux —$n$→ Digital Output @$f_s$

**Fig. 2**

**Fig. 3**

**Fig. 4**

**Fig. 5**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **JANG Y-C et al.** AN 8.8-GS/S 6-BIT CMOS TIME-INTERLEAVED FLASH ANALOG-TO-DIGITAL CONVERTER WITH MULTI-PHASE CLOCK GENERATOR. *IEICE TRANSACTIONS ON ELECTRONICS, INSTITUTE OF ELECTRONICS, TOKYO, JP,* 01 June 2007, vol. E90C (6), 1156-1164